# EUROPEAN PATENT SPECIFICATION

(11) **EP 1 082 641 B1**
(45) Date of publication and mention of the grant of the patent: **06.11.2002**
(21) Application number: 99921694.8
(22) Date of filing: 05.05.1999
(51) Int. Cl.: G03F 7/00

(54) **PHOTOSENSITIVE PASTE, SUBSTRATE FOR PLASMA DISPLAY PANEL USING THE SAME, AND METHOD OF PRODUCTION OF THE SUBSTRATE**
FOTOEMPFINDLICHE PASTE, DAMIT HERGESTELLTES PLASMAANZEIGETAFELSUBSTRAT UND VERFAHREN ZUR HERSTELLUNG DES SUBSTRATS
PATE PHOTOSENSIBLE, SUBSTRAT D'AFFICHEUR AU PLASMA LA METTANT EN OEUVRE, ET PROCEDE DE PRODUCTION DU SUBSTRAT

(30) Priority: 18.05.1998 JP 15193598
(43) Date of publication of application: 14.03.2001
(73) Proprietor: MINNESOTA MINING AND MANUFACTURING COMPANY, St. Paul, Minnesota 55133-3427 (US)
(72) Inventor: YOKOYAMA, Chikafumi, Saint Paul, MN 55133-3427 (US); KASAI, Toshihiro, Saint Paul, MN 55133-3427 (US)
(74) Representative: VOSSIUS & PARTNER
(86) International application number: US9909850
(87) International publication number: WO99060446

(56) References cited:
- EP-A- 0 722 179
- FR-A- 2 738 393
- DATABASE WPI Section PQ, Week 9706 Derwent Publications Ltd., London, GB; Class P81, AN 97-056495 XP002112472 & JP 08 304784 A (SONY CORP), 22 November 1996 (1996-11-22)

## Description

### Technical Field

The present invention relates to a photosensitive paste used for formation of a substrate for plasma display panel (hereinafter referred to as "PDP"), a substrate for PDP, and a method of production of the substrate.

### Background

A PDP for use as a thin large-picture display is generally equipped with a substrate for PDP. A typical substrate for PDP is composed of a pair of flat glass plates and ribs having a predetermined height and a predetermined width (also referred to as barrier ribs, partitions or barriers), the flat glass plates facing each other at a regular interval via the ribs. With such a composition, the rib partitions a space between a pair of flat glass plates in an airtight state to define a plurality of discharge display cells (discharge spaces) capable of emitting light by plasma discharge.

The rib of the discharge display cell can be produced, for example, by a so-called transfer method disclosed in Japanese Unexamined Patent Publication (Kokai) No. 9-265905. First, a mixture of a powder of glass or ceramics, a binder containing an organic additive, and an organic silicate compound is filled in.a mold and molded by a thermal curing reaction or a photocuring reaction. Thereafter, the resulting molded article is removed from the mold and transferred onto the flat glass plate. Then, the transferred molded article is calcined and integrally bonded with the flat glass plate to obtain a desired rib.

### Summary of the Invention

In case of the molding by the thermal curing reaction as described above, when the flat glass plate has a very large area for large-size PDP, the temperature distribution becomes considerably ununiform and thermal control often becomes very difficult. Also, in case of the molding by the photocuring reaction, a photosensitive paste generally contains lead glass, which absorbs light because of its large mass absorption coefficient, and it is not cured efficiently.

Furthermore, a binder containing an organic additive is generally undesirable for a rib as a final product to be attached to the flat glass plate, and is normally removed at high calcination temperature of 500°C. The rib generally requires melting of a glass frit and, in case of melting, a temperature higher than the calcination temperature is required. Such a high calcination temperature is likely to afford a considerably large thermal distortion to the flat glass plate. Even if the binder is removed by calcination, voids are formed between ceramics powder to afford a porous structure to the rib. Therefore, the strength of the rib is likely to be reduced. Such a reduction in strength is not preferable in view of the quality of the rib.

That is, an object of the present invention is to provide a photosensitive paste, which makes it possible to easily form a rib having improved quality, a substrate for PDP using the same, and a method of production of the same.

According to one aspect of the present invention, there is provided a lead-free photosensitive past as set forth in claim 1.

According to another aspect of the present invention, there is provided a substrate for a plasma display panel as set forth in claim 3.

According to still another aspect of the present invention there is provided a method of production of a substrate for plasma display panel as set forth in claim 2.

### Brief Description of the Drawings

Fig. 1 is an exploded perspective view schematically illustrating one embodiment of the substrate for PDP according to the present invention.
Fig. 2 is a sectional view illustrating a method of production of the substrate for PDP shown in Fig. 1 in due order.
Fig. 3 is a microphotograph (SEM) illustrating a texture state of the rib surface of the molded article produced in Example 1.
Fig. 4 is a microphotograph (SEM) illustrating a texture state of the rib surface of the molded article produced in Comparative Example 1.
Fig. 5 is a microphotograph (SEM) illustrating a texture state of the rib surface of the molded article produced in Comparative Example 2.

### Detailed Description

The present invention will be described in detail in accordance with its preferred embodiments. It will be appreciated that the present invention is not limited to these embodiments.

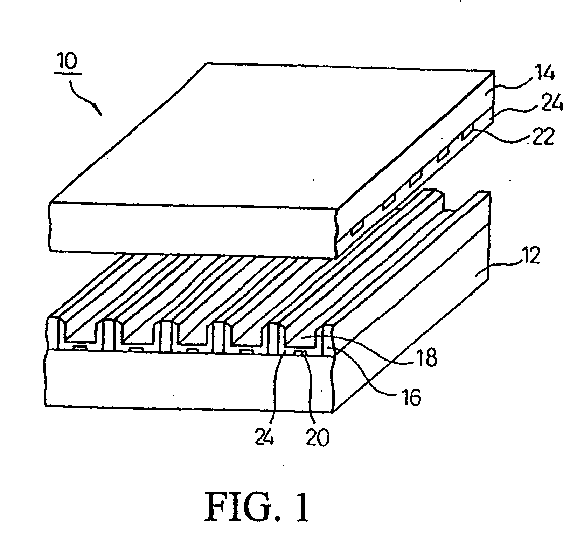

Fig. 1 is an exploded perspective view schematically illustrating one embodiment of the substrate for PDP of the present invention. A substrate for PDP 10 shown in the figure is for an AC system, and is preferably equipped with a pair of transparent flat plates facing each other at a regular interval, which are composed of easily available glass, i.e. a back plate 12 and a front plate 14. A rib 16 having a predetermined height and a predetermined width is disposed between the back plate 12 and the front plate 14, and the rib partitions a space between them, thereby making it possible to define a plurality of discharge display cells 18. Furthermore, each discharge display cell 18 is disposed with an address electrode 20 on the back plate 12 along the rib 16. On the front plate 14, a transparent bus electrode 22 of ITO (indium tin oxide) is disposed perpendicularly to the rib 16. Furthermore, a rare gas (not shown) is enclosed between these electrodes 20, 22, thereby making it possible to light emission due to discharge. On each address electrode 20, a fluorescent layer 24 may be formed in a certain order, thereby making it possible to perform color display. On the front plate 14 and the bus electrode 22, a transparent dielectric layer 24 is provided to coat the bus electrode 22, thereby contributing to inhibition of sputtering of the electrode and an increase in life of PDP.

In this embodiment, the rib 16 is composed of those obtained by calcining a molded article (not shown) attached integrally on at least one of the back plate 12 and front plate 14. Describing in more detail, this molded article is obtained by curing the photosensitive paste by radiation such as light within an ultraviolet or visible range or electron beam, not by heat. In the case of the thermal curing, thermal control is very difficult, generally. However, in this embodiment, the thermal control becomes unnecessary during the molding, substantially. Accordingly, not only is thermal influence on the back plate 12 and front plate 14 reduced, but also the quality of the rib 16 becomes uniform.

The photosensitive paste described above basically contains (1) a powder of ceramics (e.g. alumina, silica or wallnite) and (2) a photocurable binder that has a silane coupling agent having a functional group such as methacrylic group, etc., which is polymerized by radiation, such as γ-methacryloxypropyltrimethoxy-silane, γ-methacryloxypropylmethyldimethoxysilane, γ-methacryloxypropyltriethoxysilane or γ-methacryloxypropylmethyldiethoxysilane, and does not contain lead which has high toxicity and mass absorption coefficient, like a conventional photosensitive paste. Accordingly, the photosensitive paste used herein can transmit UV efficiently and hardly diminish radiation even if it has a thickness of several hundreds of micrometers (µm). This fact is very advantageous to produce a rib for PDP for which the height of about 200 µm is required.

Further, since this photosensitive paste contains little or no organic additive in the binder, it makes possible to calcine at a temperature lower than that of a conventional procedure. Accordingly, it is possible to use a flat plate of a cheap glass having a low softening point such as soda lime glass as the back plate or front plate in place of an expensive high-softening point glass. This photosensitive paste can not only reduce the cost as described above. That is, a polymer of a silane coupling agent contained in the photosensitive paste is converted into an inorganic calcined substance such as silica, etc. at a calcination temperature of about 450 to 500°C. At this time, the calcined substance exists between powders of ceramics such as alumina, etc. and functions as a binding medium for performing dense bonding of them, thereby affording a dense structure for increasing the strength to the molded article after calcination. As a result, the molded article after calcination has a shrinkage factor of about 1% and has high processing accuracy.

It is preferred that the silane coupling agent constituting the binder has a molecular weight of about 232 to 290, taking the availability into consideration. This photosensitive paste contains a surfactant or mineral acid, if necessary, and has a viscosity of about 1 × 10⁴ to 1 × 10⁶ centipoise (cps). Because such a viscosity is suited to fill a paste in a mold for forming a rib with good accuracy.

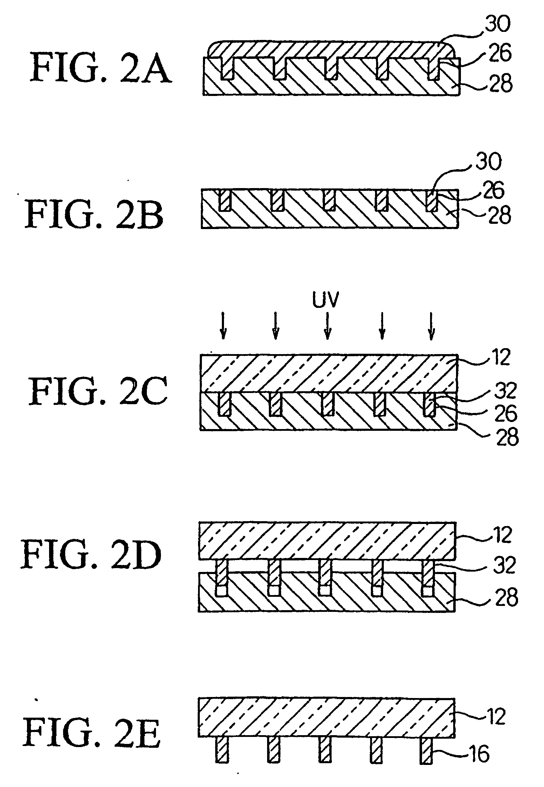

The method of production of the substrate for PDP of this embodiment will be described in order of step with reference to Fig. 2.

First, although it is not illustrated, a photosensitive paste is prepared by mixing a silane coupling agent having a methacrylic group and a predetermined molecular weight and a powder of alumina or silica with a medium such as water, etc. Alternatively, a sol may be formed by mixing them with mineral acid such as hydrochloric acid or sulfuric acid in place of water, and hydrolyzing the silane coupling agent. In this case, the photosensitive paste does not cause gelation after drying and enables the powder to uniformly disperse therein. The viscosity does not vary with the amount of water added and keeps constant, resulting in preferred one.

Then, a mold 28 having a concave portion 26 corresponding to the shape of the rib of the substrate for PDP to be produced is prepared, and a photosensitive paste 30 is applied on the mold 28 to fill the concave portion 26 with the photosensitive paste 30 (see step (A)). At this time, the concave portion 26 may have a trapezoidal cross section. Alternatively, although it is not shown, a releasant may be applied on the surface to impart high releasability to the mold 28. Subsequently, excess photosensitive paste 30 on the mold 28, which is not poured into the concave portion 26, is removed by a scraper (not shown) to make the surface of the mold 28 smooth (see step (B)).

After filling the concave portion 26 of the mold 28 with the photosensitive paste 30, a transparent back plate 12 is placed on the mold 28 to bring it into contact with the photosensitive paste 30 of the concave portion 26 (see step (C)). Then, as shown by the arrow in the step (C), the photosensitive paste 30 of the concave portion 26 is exposed to the above radiation via the back plate 12. At this time, the photosensitive paste 30 of the concave portion 26 is easily cured by single exposure step to form a molded article 32 because it has high UV transmission as described above. That is, simplification of the production steps can be performed. As is apparent from a comparison with a screen printing method of forming a rib by repetition of laminating of a photosensitive paste and radiation exposure (not shown), simplification of the steps can be performed.

After UV radiation exposure, an integrally bonded molded article 32 is removed from the mold 28 (see step (D)). Then, the back plate 12, to which the molded article 32 is attached, is placed in a calcination furnace (not shown) and calcined at comparatively low temperature such as about 400 to 500°C, at which the back plate and molded article are not thermally deformed, to obtain a rib 16 (see step (E)).

Subsequently, although it is not shown, an address electrode is formed between ribs on the back plate and, if necessary, a fluorescent layer may be provided on the address electrode. Thereafter, a transparent front plate, on which a bus electrode is previously formed, may also be disposed via the rib so that the front plate and back plate face each other. Then, the peripheral portions of the front plate and back plate are sealed in an airtight state by using a sealing material (not shown) and a discharge display cell may be formed between the front plate and back plate. After the discharge display cell is vacuum-extracted, a rare gas such as helium, neon, etc. may be introduced to form a substrate for PDP.

The present invention was described with reference to an AC substrate for PDP, but it is apparent to persons skilled in the art that the present invention can also be applied to a DC substrate for PDP. Regardless of the DC/AC substrates for PDP, formation of the electrode may be performed before forming the rib.

### Examples

The following Examples further illustrate the present invention in detail but are not to be construed to limit the scope thereof.

### Example 1

First, a photosensitive paste was prepared as follows. To 4 g of γ-methacryloxypropyldimethyldimethoxysilane (manufactured by Nippon Yunicar Co., Ltd.) as a silane coupling agent, 2.7 g of a mixed solution of an aqueous 0.1N nitric acid solution and ethanol in a molar ratio of 1:2 was added. The mixture was reacted with sufficiently stirring at 70°C for 12 hours. The reaction product was vacuum-dried at room temperature to obtain a viscous liquid having a viscosity of 10 cps.

To this viscous liquid, 14 g of α-alumina having an average particle diameter of 0.5 µm was added while adding dropwise 0.05 g of Dyrocure™ 1173 (2-hydroxy-2-methyl-1-phenyl-propan-1-one, manufactured by Ciba-Gigy Co.) as a photocuring initiator and 0.04 g of POCA (phosphate polyoxyalkyl polyol) as a surfactant, to obtain a photosensitive paste. At this time, assumed that all of methoxy groups of γ-methacryloxypropyldimethyldimethoxysilane are hydrolyzed in the viscous liquid, this paste has an inorganic solid content of 86% by weight.

Then, the photosensitive paste obtained as described above was applied on a plastic mold having a concave portion corresponding to the shape of a rib to fill the concave portion with the photosensitive paste. This concave portion is designed to produce a substrate for PDP, which has a cell pitch of 230 µm, a rib height of 200 µm, an opening size of the cell upper surface of 80 µm and a cell bottom size of 110 µm.

Then, a back plate of soda lime glass was placed on the mold to bring it into contact with the photosensitive paste of the concave portion. Using an ultraviolet (UV) light source (trade name: Unicure) manufactured by Ushio Denki Co., Ltd., the photosensitive paste of the concave portion was cured by an exposure source of UV having a wavelength of 200 to 450 nm via the back plate for 30 seconds to obtain a molded article.

Then, the molded article bonded integrally with the back plate was removed from the mold and the molded article was calcined at a predetermined temperature of 450 to 550°C to obtain a rib. In this case, deformation of the molded article was not observed. In addition, the shrinkage factor of the molded article was low enough to permit the processing accuracy. That is, the shrinkage factor of the molded article was 0.35% in case of calcination at 450°C whereas the shrinkage factor was 1.5% in case of calcination at 550°C.

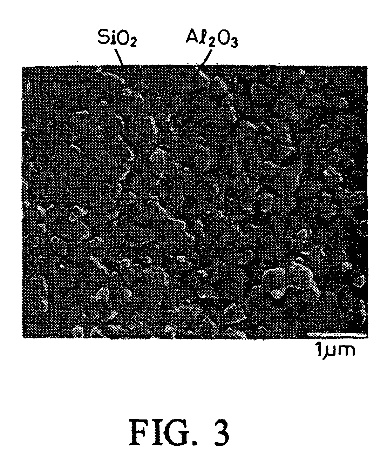

A microphotograph obtained by SEM observation of the surface of the rib calcined at 450°C is shown in Fig. 3. From the SEM of Fig. 3, it was observed that silica (SiO₂) obtained in calcination of the silane coupling agent exists between alumina (Al₂O₃) particles to form a binding medium such as binder of particles thereof, thereby affording a dense structure to the rib. It was also found that this rib has strength enough to endure deformation of the pressure by fingers.

### Comparative Example 1

According to the substantially same manner and condition as those described in Example 1 except for preparing the photosensitive paste as follows, a rib was produced.

First, a mixture prepared by mixing 2.5 g of glass (trade name: ASF1273, manufactured by Asahi Glass Co., Ltd.), which has an average particle diameter of 1 µm and contains a large amount of lead, with 5.7 g of α-alumina having an average particle diameter of 0.5 µm in a weight ratio of 3:7 was dispersed in 1 g of DMA (dimethylacrylamide) as a photocuring monomer to prepare a paste.

To this paste, 0.02 g of Dyrocure™ 1173 (2-hydroxy-2-methyl-1-phenyl-propan-1-one, manufactured by Ciba-Gigy Co.) as a photocuring initiator and 0.02 g of POCA (phosphate polyoxyalkyl polyol) as a surfactant were added to obtain a photosensitive paste.

In case of curing such a photosensitive paste using the same light source as that used Example 1, even if UV exposure was performed for 3 minutes, only the photosensitive paste of the concave portion, which exists within the range from the surface of the mold to 100 µm in depth at most, was cured and the photosensitive paste existing in the deeper position was not cured.

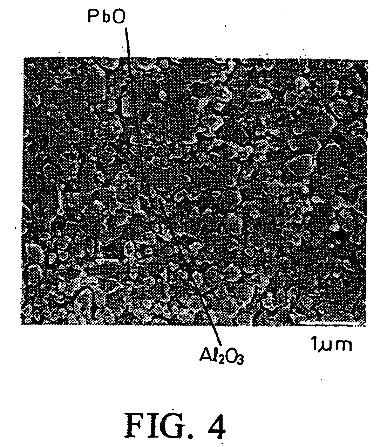

Even if the partially cured molded article was calcined at 450°C, it was not sufficiently sintered. A microphotograph obtained by SEM observation of the rib obtained by calcining the partially cured molded article at 450°C is shown in Fig. 4. From the SEM of Fig. 4, it was observed that insufficiently molten lead (PbO) glass does not function as a binding medium such as binder for alumina (Al₂O₃). That is. it was found that the rib has a very brittle porous structure. It was also found that this rib is easily deformed and broken by fingers' touch. Therefore, the shrinkage coefficient of the molded article could not be measured.

### Comparative Example 2

According to the almost same manner and condition as those described in Example 1 except for preparing the photosensitive paste as follows, a rib was produced.

First, 5 g of α-alumina having an average particle diameter of 0.5 µm (manufactured by Sumitomo Chemical Industries Co., Ltd.) was dispersed in 1 g of DMA (dimethylacrylamide) as a photocuring monomer to prepare a viscous liquid.

To this liquid, 0.02 g of Dyrocure™ 1173 (2-hydroxy-2-methyl-1-phenyl-propan-1-one, manufactured by Ciba-Gigy Co.) as a photocuring initiator and 0.02 g of POCA (phosphate polyoxyalkyl polyol) as a surfactant were added to obtain a photosensitive paste.

Then, a back plate of sodium lime glass was placed on a mold to bring it into contact with the photosensitive paste which has already filled in the concave portion of the mold. Then, using the same UV light source as that used in Example 1, the photosensitive paste of the concave portion was cured by UV (wavelength: 200 to 450 nm) exposure via the back plate for 30 seconds to obtain a molded article.

Even if the partially cured molded article was calcined at 450°C, it was not sufficiently sintered. It was also found that this rib is easily deformed and broken by fingers' touch. Therefore, the shrinkage coefficient of the molded article could not be measured.

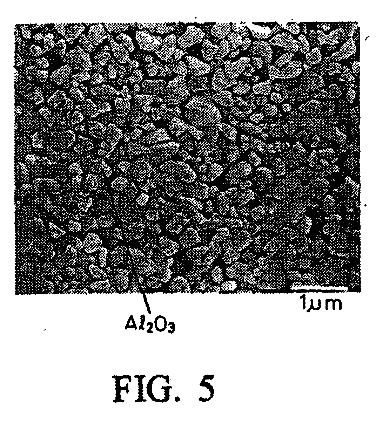

For reference, a rib was produced by calcining only the molded article at 1000°C. This rib was not easily deformed and broken in comparison with that obtained at the calcination temperature of 450°C. A microphotograph obtained by SEM observation of this rib is shown in Fig. 5. From the SEM of Fig. 5, it was observed that the rib of this example has a porous structure containing voids formed by calcination of DMA between alumina (Al₂O₃) particles in comparison with the rib of Example 1. It was also found that, since the calcination temperature of 1000°C is likely to deform the back plate so that an airtight discharge display cell can not be formed, such a paste can not be attached to the flat glass plate and is not suited to forming a rib on the glass flat plate.

## Claims

1. A lead-free photosensitive paste (30) for plasma display panels comprising:
a lead-free ceramic powder, and
a photocurable binder that includes a silane coupling agent having a functional group,
wherein the photosensitive paste (30) is capable of being molded, cured by radiation, and calcined at temperatures of 500°C or less.

2. A method of production of a substrate for plasma display panel (10), wherein a rib (16) is provided on a transparent flat plate, comprising the steps of:
placing the photosensitive paste (30) described in claim 1 between the flat plate (12) and a mold (28) having a concave portion (26) corresponding to a shape of the rib (16) to fill the concave portion (26) of the mold (28) with the photosensitive paste,
curing the binder of the photosensitive paste (30) by radiation exposure of the photosensitive paste (30) to form a molded article (32),
removing the molded article (32) integrally with the flat plate (12) from the mold (28), and
calcining the cured molded article (32) to interpose an inorganic calcined substance, formed from the binder of the photosensitive paste (30), between powders of the photosensitive paste (30) described in claim 1.

3. A substrate for a plasma display panel (10) obtainable by the method of claim 2, wherein the rib (16) defines a discharge space capable of emitting hight by plasma discharge.

## Patentansprüche

1. Bleifreie Fotoempfindliche Paste (30) für Plasmaanzeigetafeln mit:
einem bleifreien Keramikpulver und
einem foto-härtbaren Binder, der einen Silanhaftvermittler mit einer funktionellen Gruppe aufweist,
wobei die fotoempfindliche Paste (30) geformt, durch Strahlung gehärtet und bei einer Temperatur von 500 °C oder weniger kalziniert werden kann.

2. Verfahren zur Herstellung eines Substrats für eine Plasmaanzeigetafel (10), wobei eine Rippe (16) auf einer transparenten flachen Platte vorgesehen ist, mit den Schritten:
Einbringen einer fotoempfindlichen Paste (30) nach Anspruch 1 zwischen die flache Platte (12) und eine Form (28) mit einem konkaven Abschnitt (26) entsprechend einer Form der Rippe (16), um den konkaven Abschnitt (26) der Form (28) mit der fotoempfindlichen Paste zu füllen,
Härten des Binders der fotoempfindlichen Paste (30) durch Strahlungseinwirkung auf die fotoempfindliche Paste (30), um ein Formteil (32) auszubilden,
Entfernen des Formteils (32) einstückig mit der flachen Platte (12) aus der Form (28) und
Kalzinieren des gehärteten Formteils (32), um eine anorganische kalzinierte Substanz, die aus dem Binder der fotoempfindlichen Paste (30) gebildet wird, zwischen Pulverpartikeln der fotoempfindlichen Paste (30) nach Anspruch 1 anzuordnen.

3. Substrat für eine Plasmaanzeigetafel (10), das nach dem Verfahren nach Anspruch 2 herstellbar ist, wobei die Rippe (16) einen Entladungsraum begrenzt, der Licht durch Plasmaentladung emittieren kann.

## Revendications

1. Pâte photosensible sans plomb (30) pour des panneaux d'écran à plasma comprenant :
une poudre de céramique sans plomb, et
un liant photodurcissable qui comprend un agent de couplage silane ayant un groupe fonctionnel,
dans laquelle la pâte photosensible (30) est capable d'être moulée, durcie par rayonnement, et calcinée à des températures de 500°C ou moins.

2. Procédé de production d'un substrat pour panneau d'écran à plasma (10), dans lequel une nervure (16) est produite sur une plaque plane transparente, comprenant les étapes consistant à :
placer la pâte photosensible (30) décrite à la revendication 1 entre la plaque plane (12) et un moule (28) ayant une portion concave (26) correspondant à une forme de la nervure (16) pour remplir la portion concave (26) du moule (28) avec la pâte photosensible,
durcir le liant de la pâte photosensible (30) par exposition à un rayonnement de la pâte photosensible (30) pour former un article moulé (32),
retirer l'article moulé (32) intégralement avec la plaque plane (12) du moule (28), et
calciner l'article moulé durci (32) pour interposer une substance inorganique calcinée, formée à partir du liant de la pâte photosensible (30), entre les poudres de la pâte photosensible (30) décrites à la revendication 1.

3. Substrat pour un panneau d'écran à plasma (10) qu'on peut obtenir par le procédé selon la revendication 2, dans lequel la nervure (16) définit un espace de décharge capable d'émettre de la lumière par décharge plasma.
